# FASCICULE DE BREVET EUROPEEN

(11) **EP 3 826 015 B1**
(45) Date de publication et mention de la délivrance du brevet: **29.03.2023**
(21) Numéro de dépôt: 20206354.1
(22) Date de dépôt: 09.11.2020
(51) Int. Cl.: G11C 11/419, G06F 11/10, G11C 7/10

(54) **PROCÉDÉ D'ÉCRITURE DANS UNE MÉMOIRE VOLATILE ET CIRCUIT INTÉGRÉ CORRESPONDANT**
VERFAHREN ZUM SCHREIBEN IN EINEN FLÜCHTIGEN SPEICHER, UND ENTSPRECHENDER INTEGRIERTER SCHALTKREIS
METHOD FOR WRITING IN A VOLATILE MEMORY AND CORRESPONDING INTEGRATED CIRCUIT

(30) Priorité: 21.11.2019 FR 1913001
(43) Date de publication de la demande: 26.05.2021
(73) Titulaire: STMicroelectronics (Rousset) SAS, 13790 Rousset (FR)
(72) Inventeur: EVA, Christophe, 13790 ROUSSET (FR); GRIL-MAFFRE, Jean-Michel, 13090 AIX EN PROVENCE (FR)
(74) Mandataire: Casalonga

(56) Documents cités:
- FR-A1- 2 864 321
- US-A1- 2010 162 068

## Description

Des modes de réalisation et de mise en oeuvre concernent les circuits intégrés, par exemple des circuits intégrés de systèmes sur puces, comprenant une mémoire vive utilisant un code correcteur d'erreur.

Les codes correcteurs d'erreurs (ou ECC pour « Error Correction Code » en anglais), typiquement sous la forme d'un code de Hamming, permettent de repérer et corriger au moins une erreur dans un mot mémoire d'une mémoire. Un code correcteur d'erreur est calculé en connaissance de toutes les données d'un mot mémoire auquel il est dédié.

Un mot mémoire est classiquement une unité de l'organisation et de l'accès d'une mémoire. Un mot mémoire comprend typiquement plusieurs bits de données, ou plusieurs octets de huit bits de données, ainsi que les bits du code correcteur d'erreur dédié.

Cela étant, certaines mémoires permettent une écriture de données à une granularité plus petite qu'un mot mémoire, par exemple une granularité d'un octet ou d'un bit, et le code correcteur d'erreur doit être recalculé sur le nouveau mot mémoire modifié et complet. Typiquement, une lecture des anciennes données non modifiées est prévue, avant d'écrire le nouveau mot mémoire et son code correcteur d'erreur.

Des solutions proposent d'intercaler des étapes de lecture, de calcul du code et d'écriture de deux instructions d'écriture successives, et, un nouveau mot mémoire modifié est stocké dans un registre tampon jusqu'à la prochaine instruction d'écriture, au cours de laquelle il sera écrit dans la mémoire.

Ainsi, si le dispositif de mémoire est réinitialisé, les données enregistrées dans le registre tampon sont perdues, alors qu'elles ont été commandées en écriture dans la mémoire vive.

On entend par réinitialisation une réinitialisation commandée par un signal du type « reset », contrairement à un redémarrage ou une coupure d'alimentation. Une mémoire vive, par exemple du type mémoire vive statique (ou SRAM pour « Static Random Access Memory » en anglais), ne perd pas nécessairement les données stockées en cas de réinitialisation.

Le document US 2010/162068 A1 décrit un dispositif de mémoire comprenant : un réseau de cellules de mémoire ; un circuit de détection et de correction d'erreurs ; et un registre tampon disposé pour stocker temporairement des données d'écriture et de lecture.

Le document FR 2864321 A1 décrit un circuit de mémoire dynamique à accès aléatoire comprenant un plan mémoire, deux registres tampons couplés au plan mémoire permettant la lecture et/ou l'écriture, et un circuit de correction d'erreur permettant des cycles de lecture-modification-écriture appliqués à un groupe de n mots au sein d'une même page.

Des modes de mise en oeuvre et de réalisation proposés permettent de ne plus subir une perte de données censées être effectivement écrites dans la mémoire vive, notamment en cas de réinitialisation du système.

Selon un aspect il est ainsi proposé un procédé d'écriture dans une mémoire volatile comprenant au moins une réception d'une requête d'écriture dans la mémoire, et, en réponse à chaque requête d'écriture dans la mémoire :
- une préparation des données à écrire dans la mémoire comprenant un calcul d'un code correcteur d'erreur ;
- un enregistrement dans un registre tampon des données à écrire dans la mémoire ; et
- si aucune nouvelle requête d'écriture ou de lecture dans la mémoire n'est reçue après ledit enregistrement, une écriture dans la mémoire des données à écrire enregistrées dans le registre tampon.

En d'autres termes il est proposé d'enregistrer systématiquement les dernières données à écrire, préparées dans le registre tampon, sans pour autant ajouter un délai qui serait cumulé dans une série d'écritures successives, mais en n'ajoutant une écriture qu'au moment avantageux où la mémoire est libre, lorsqu'aucune écriture ou lecture dans la mémoire n'est requise.

Selon un mode de mise en oeuvre, le procédé comprend en outre :
- si une nouvelle requête d'écriture dans la mémoire est reçue après ledit enregistrement, une écriture dans la mémoire des données à écrire enregistrées dans le registre tampon avant l'enregistrement dans le registre tampon des données suivantes à écrire dans la mémoire préparées en réponse à la nouvelle requête d'écriture dans la mémoire.

Ainsi, le procédé bénéficie à la fois d'un gain de temps en cas de série de requêtes d'écritures successives, et d'une sécurité vis-à-vis de la perte des dernières données, notamment en cas de réinitialisation.

Selon un mode de mise en oeuvre, la requête d'écriture dans la mémoire comprend une adresse mémoire de la mémoire et des nouvelles données ayant une taille inférieure à la taille d'un mot mémoire de la mémoire, ladite préparation des données à écrire comprend une lecture de données antérieures enregistrées dans le mot mémoire contenant l'adresse mémoire, et le calcul du code correcteur d'erreur est calculé sur une combinaison des données antérieures et des nouvelles données, les données à écrire comprenant ladite combinaison de données et le code correcteur d'erreur ainsi calculé.

Selon un mode de mise en oeuvre, ladite au moins une requête d'accès dans la mémoire est transmise sur un bus et comprend une activation d'un signal de sélection sur une voie d'un bus du type bus système avancé, le procédé comprenant une détection sur l'activation ou non dudit signal de sélection pour évaluer si aucune requête d'accès en écriture ou en lecture dans la mémoire n'est reçue après ledit enregistrement.

Selon un autre aspect, il est proposé un circuit intégré comprenant une mémoire volatile et une interface de contrôle de la mémoire destinée à recevoir au moins une requête d'écriture dans la mémoire, et configurée, en réponse à une requête d'écriture de données nouvelles dans la mémoire, pour :
- préparer des données à écrire dans la mémoire et calculer un code correcteur d'erreur ;
- enregistrer dans un registre tampon les données à écrire dans la mémoire ; et
- si aucune nouvelle requête d'écriture ou de lecture dans la mémoire n'est reçue après ledit enregistrement, commander une écriture dans la mémoire des données à écrire enregistrées dans le registre tampon.

Selon un mode de réalisation, l'interface de contrôle est en outre configurée pour :
- si une nouvelle requête d'écriture dans la mémoire est reçue après ledit enregistrement, écrire dans la mémoire les données à écrire enregistrées dans le registre tampon avant d'enregistrer dans le registre tampon les données suivantes à écrire dans la mémoire préparées en réponse à la nouvelle requête d'écriture dans la mémoire.

Selon un mode de réalisation, l'interface de contrôle est configurée comme défini ci-avant, en réponse à une requête d'écriture comprenant une adresse mémoire de la mémoire et des nouvelles données ayant une taille inférieure à la taille d'un mot mémoire de la mémoire, et ladite interface de contrôle de la mémoire est configurée pour lire des données antérieures enregistrées dans le mot mémoire contenant l'adresse mémoire, et calculer le code correcteur d'erreur sur une combinaison des données antérieures et des nouvelles données, afin de préparer lesdites données à écrire comprenant la combinaison de données et le code correcteur d'erreur ainsi calculé.

Selon un mode de réalisation, l'interface de contrôle de la mémoire comporte un circuit d'écriture forcée configuré pour évaluer si aucune requête d'écriture ou de lecture dans la mémoire n'est reçue après ledit enregistrement, et pour commander ladite écriture dans la mémoire des données à écrire enregistrées dans le registre tampon pendant l'absence d'écriture et de lecture dans la mémoire.

Selon un mode de réalisation, ladite mémoire volatile est du type mémoire vive statique.

Selon un mode de réalisation, l'interface de contrôle de la mémoire est configurée pour recevoir ladite au moins une requête d'accès dans la mémoire sur un bus, et l'interface de contrôle de la mémoire est configurée pour détecter l'activation ou non d'un signal de sélection sur une voie dudit bus, afin d'évaluer si aucune requête d'accès en écriture ou en lecture dans la mémoire n'est reçue après ledit enregistrement.

Il est également proposé un système sur puce comprenant un circuit intégré tel que défini ci-avant, un bus, et un dispositif maître capable de transmettre des requêtes d'écriture dans la mémoire à l'interface de contrôle de la mémoire via ledit bus.

D'autres avantages et caractéristiques de l'invention apparaîtront à l'examen de la description détaillée de modes de mise en oeuvre et de réalisation, nullement limitatifs, et des dessins annexés sur lesquels :
[Fig 1]
[Fig 2]
[Fig 3]

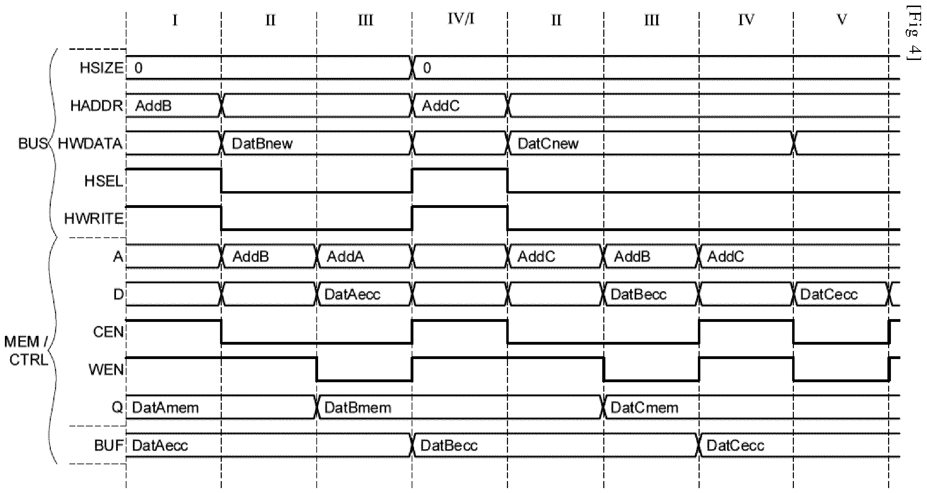

[Fig 4] illustrent des modes de mise en oeuvre et de réalisation de l'invention.

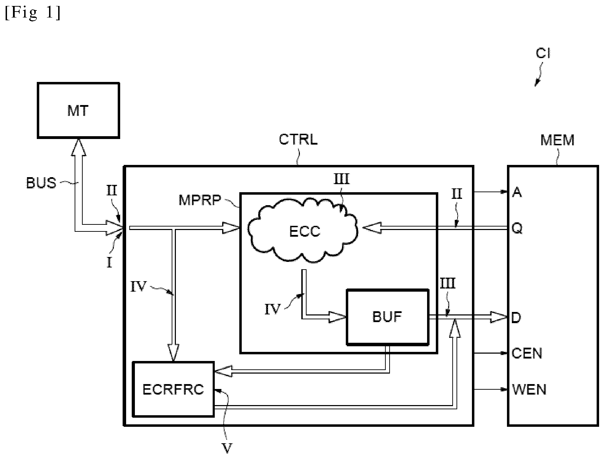

La figure 1 illustre un système sur puce CI, réalisé de façon intégré.

Le système sur puce CI comporte un dispositif maître MT, par exemple un processeur de microcontrôleur, et un circuit intégré comprenant une mémoire vive MEM et une interface de contrôle de la mémoire CTRL.

La mémoire vive MEM est par exemple du type mémoire vive statique « SRAM » (acronyme du terme anglosaxon usuel « Static Random Access Memory »), l'interface de contrôle permet de commander la mémoire MEM, en réponse à des instructions ou des requêtes transmises par le dispositif maître MT sur un bus BUS, par exemple du type bus système avancé « AHB » (acronyme du terme anglosaxon usuel « Advanced High-performance Bus »).

L'interface de contrôle de la mémoire CTRL est configurée pour recevoir les communications du dispositif maître MT sur le bus BUS, décoder ces informations selon le protocole utilisé et exécuter les requêtes reçues en générant des signaux internes commandant la mémoire.

Ainsi l'interface de contrôle CTRL est configurée pour générer un signal d'adresse sur la ligne d'adresse A, un signal de données sur la ligne de donnée D, un signal inversé d'activation de dispositif CEN, et un signal inversé de commande d'écriture WEN, ainsi que pour lire un signal sortant Q de la mémoire, tels que ces signaux sont décrits ci-après en relation avec la figure 4.

L'interface de contrôle de la mémoire CTRL comporte un circuit de préparation des données à écrire MPRP capable de mettre en oeuvre un mécanisme de code correcteur d'erreur ECC, et d'enregistrer temporairement dans un registre tampon BUF les données à écrire dans la mémoire.

L'interface de contrôle de la mémoire CTRL comporte en outre un moyen d'écriture dite « forcée », ECRFRC, configuré pour évaluer, par exemple sur au moins certains signaux du bus BUS, si aucune requête d'écriture ou de lecture dans la mémoire n'est reçue après l'enregistrement des dernières données préparées dans le registre tampon BUF.

Et, si aucune requête d'accès à la mémoire n'est reçue, le moyen d'écriture forcée ECRFRC est configuré pour commander une écriture dans la mémoire MEM des données à écrire enregistrées dans le registre tampon BUF, pendant que la mémoire n'est ni en cours de lecture ni en cours d'écriture.

Les références I, II, III, IV, V représentent schématiquement sur la figure 1 la manière dont sont mises en oeuvre les cinq phases respectives décrites ci-après en relation avec la figure 2 ou avec les figures 3 et 4.

Ainsi, une requête d'accès en écriture de la première phase 1 est reçue par l'interface de contrôle CTRL sur le bus BUS.

Une préparation des données à écrire dans la mémoire comprend une lecture des anciennes données de la mémoire MEM, lors de la deuxième phase II, qui sont transmises au moyen de préparation MPRP sur la ligne de sortie Q de la mémoire, à l'issue de la deuxième phase II.

Des nouvelles données à écrire sont par exemple reçues sur le bus BUS lors de la deuxième phase II.

Un calcul du code correcteur d'erreur ECC est exécuté sur une combinaison des anciennes données et des nouvelles données, par le circuit de préparation des données MPRP lors de la troisième phase III.

Des données précédemment préparées et temporairement enregistrées dans le registre tampon BUF sont envoyées sur la ligne de données D de la mémoire, lors de la troisième phase III, libérant ainsi le registre tampon pour recevoir les données en cours de préparation. Une écriture des données reçues sur la ligne de données D est commandée par les signaux CEN et WEN.

Lorsque le calcul du code correcteur d'erreur est terminé, à l'issue de la troisième phase III, les données préparées pour être écrites dans la mémoire sont enregistrées dans le registre tampon BUF, lors de la quatrième phase IV.

En même temps, le moyen d'écriture forcée ECRFRC est configuré pour évaluer, sur au moins une voie du bus BUS, par exemple une voie de sélection HSEL (figure 4), si une nouvelle lecture ou écriture est requise dans la mémoire, au début de la quatrième phase IV.

Si une requête est reçue, la quatrième phase IV est superposée à la nouvelle première phase I de la nouvelle requête.

Si aucune requête n'est détectée, le moyen d'écriture forcée ECRFRC commande une écriture des données présentes dans le registre tampon BUF au cours d'une cinquième phase V.

Par exemple, le moyen d'écriture forcée ECRFRC peut être configuré pour avoir accès au registre tampon BUF et transférer les données du registre sur la voie de données D de la mémoire MEM.

Ainsi, si le système CI est par exemple réinitialisé et que le registre tampon BUF est vidé, les dernières données préparées pour l'écriture ont été effectivement écrites dans la mémoire MEM et ne sont pas perdues.

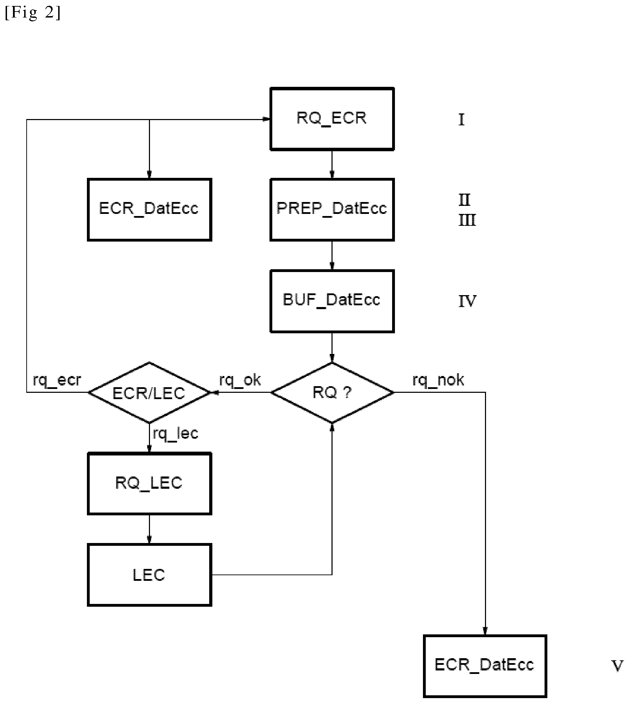

La figure 2 représente un exemple de mode de mise en oeuvre d'une écriture dans une mémoire, en réponse à une requête d'écriture RQ_ECR.

Le procédé selon cet exemple est voué à être mis en oeuvre par une interface de contrôle de la mémoire CTRL (figure 1). La mémoire est par exemple du type mémoire vive statique « SRAM », organisée en mot-mémoires. La mémoire est capable de recevoir des données à écrire ayant une taille plus petite qu'un mot mémoire et utilise un mécanisme de code correcteur d'erreur attribué à chaque mot mémoire.

Lors d'une première phase I, une requête d'accès en écriture dans la mémoire RQ_ECR est reçue. La requête d'écriture RQ_ECR peut provenir d'un dispositif maître et peut comprendre une adresse de la mémoire et les nouvelles données à écrire dans la mémoire à cette adresse.

On considère que des nouvelles données ont une taille inférieure à la taille d'un mot mémoire de la mémoire.

Lors d'une deuxième phase II, les données à écrire dans la mémoire sont préparées PREP_DatEcc, et un calcul d'un code correcteur d'erreur va être exécuté. Le calcul utilise tous les bits du mot mémoire dans lequel est incluse l'adresse de la requête.

Ainsi les données antérieures enregistrées dans le mot mémoire contenant l'adresse de la requête sont d'abord lues lors de la deuxième phase II.

Les données antérieures lues dans la mémoire sont transmises à l'interface de contrôle.

Lors d'une troisième phase III, le calcul du code correcteur d'erreur est effectué sur les données lues dans la mémoire et combinées avec les nouvelles données de la présente requête RQ_ECR.

Et, parallèlement à la préparation des données à écrire PREP_DatEcc, des données à écrire préparées précédemment sont écrites ECR_DatEcc dans la mémoire, lors de la troisième phase III.

Lors d'une quatrième phase IV, les données à écrire issues de la préparation PREP_DatEcc sont enregistrées dans un registre tampon BUF_DatEcc, vidé pour l'écriture ECR_DatEcc des données à écrire préparées précédemment.

Ensuite, un test RQ permet d'évaluer si une nouvelle requête en écriture ou en lecture dans la mémoire est reçue rq_ok, ou non rq_nok.

En cas de réception d'une nouvelle requête rq_ok, une distinction ECR/LEC est faite entre une nouvelle requête d'écritures rq_ecr et une nouvelle requête de lecture rq_lec.

Si une requête d'écriture est reçue rq_ecr, alors les phases I, II, III et IV telles que décrites ci-dessus sont exécutées avec la nouvelle requête en écriture RQ_ECR, et comprennent notamment une écriture ECR_DatEcc des données à écrire, enregistrées dans le registre tampon BUF_DatEcc lors de la phase IV décrite ci-dessus.

Si une requête en lecture RQ_LEC est reçue rq_lec, alors la lecture LEC est mise en oeuvre, puis le test RQ est de nouveau réalisé.

Si aucune nouvelle requête rq_nok d'écriture ou de lecture dans la mémoire n'est reçue, alors les dernières données à écrire enregistrées dans le registre tampon ECR_DatEcc sont écrites dans la mémoire, lors d'une cinquième phase V, pendant l'absence d'écriture et de lecture dans la mémoire.

Ainsi le procédé selon cet exemple permet de ne pas stocker dans le registre tampon les dernières données préparées pour être écrites dans la mémoire, sans pour autant contraindre ou retarder l'exécution des nouvelles requêtes d'écriture RQ_ECR ou de lecture RQ_ECR subséquentes à la préparation PREP_DatEcc et l'enregistrement BUF_DatEcc des données à écrire.

L'exemple de procédé décrit ci-dessus en relation avec la figure 2 peut bien entendu être adapté à toute écriture dans une mémoire prévoyant un code correcteur d'erreur et un tel usage d'un registre tampon, selon les différents protocoles de transmission de requêtes utilisés.

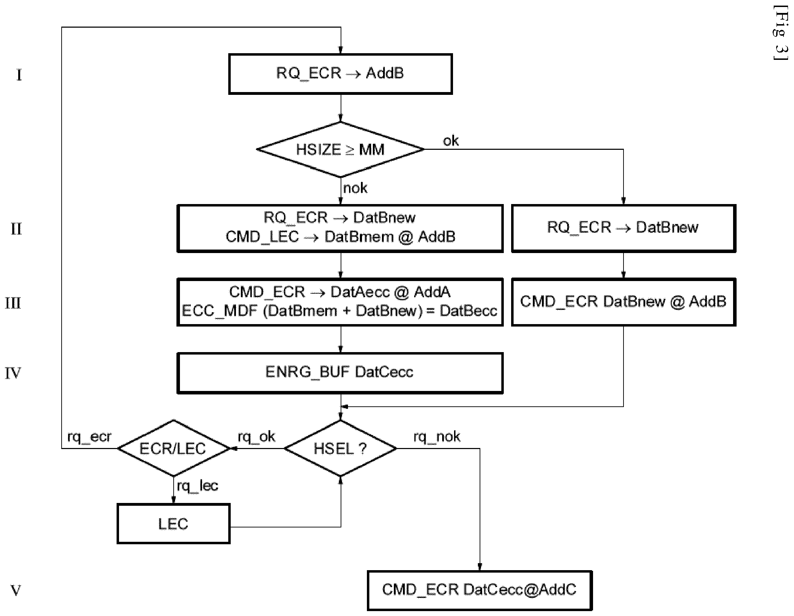

Les figures 3 et 4 illustrent à cet égard un exemple d'application du procédé décrit ci-dessus en relation avec la figure 2 dans le cadre d'une requête formalisée selon un protocole de communication sur un bus de microcontrôleur du type bus avancé haute performance « AHB » (acronyme du terme anglosaxon usuel « Advanced High-performance Bus ») spécifié dans la norme des architectures avancées de bus de microcontrôleur « AMBA » (acronyme du terme anglosaxon usuel « Advanced Microcontroller Bus Architecture ») bien connue de l'homme de l'art.

La figure 3 représente les étapes de procédé selon cet exemple et la figure 4 représente des signaux en jeu sur le bus BUS et de l'interface de contrôle CTRL à la mémoire MEM selon cet exemple.

On utilisera dans la suite les références des signaux en jeu sur le bus BUS pour désigner indistinctement les voies du bus BUS ou les signaux transmis sur ces voies.

Les cycles I, II, III, IV, et V, sont définis par le protocole AHB et correspondent fonctionnellement aux phases respectives du procédé décrit ci-avant en relation avec la figure 2.

Le premier cycle I correspond à un cycle de contrôle du protocole AHB, une requête en écriture RQ_ECR est communiqué à la mémoire par une transmission de l'adresse des nouvelles données à écrire AddB sur une voie respective HADDR du bus BUS, ainsi que par une activation d'un signal de sélection HSEL et d'un signal de commande d'écriture HWRITE sur des voies respectives du bus BUS.

Lors du premier cycle I, une information de taille des données à écrire (qui ne sont pas encore transmises) est communiquée sur une voie respective HSIZE du bus BUS.

Si la taille HSIZE des données à écrire est égale à la taille d'un mot mémoire MM de la mémoire, alors une écriture directe CMD_ECR des nouvelles données DatBnew est commandée sur le mot de l'adresse transmise AddB dans la requête RQ_ECR, après la transmission des nouvelles données DatBnew (voir le deuxième cycle II ci-dessous).

Si la taille HSIZE des données à écrire est inférieure à la taille d'un mot mémoire MM de la mémoire, alors une préparation des données à écrire est mise en oeuvre de la façon suivante.

Lors du deuxième cycle II, les nouvelles données DatBnew de la requête en écriture RQ_ECR sont transmises sur une voie respective HWDATA du bus BUS.

L'adresse AddB est chargée sur une ligne d'adresse A de la mémoire MEM, et la mémoire MEM est commandée en lecture CMD_LEC à l'adresse AddB par mise à 0 d'un signal inversé d'activation de dispositif CEN, et maintient à 1 d'un signal inversé d'écriture WEN.

Lors du troisième cycle III, les données lues dans la mémoire DatBmem sont transmises à l'interface de contrôle sur une sortie Q de la mémoire.

Une adresse AddA de données préparées précédemment est chargée sur la ligne d'adresse A de la mémoire, et des données préparées précédemment DatAecc sont chargées sur une ligne d'entrée de données D de la mémoire, en provenance d'un registre tampon BUF de l'interface de contrôle. Les données préparées précédemment DatAecc résultent d'une précédente préparation de données, comme décrit ci-après sous la référence ECC_MDF.

La mémoire MEM est commandée en écriture CMD_ECR par mise à 0 du signal inversé d'activation de dispositif CEN, et mise à 0 du signal inversé d'écriture WEN. Cela correspond à une activation du signal de commande d'écriture sur la ligne WEN.

L'écriture est exécutée à l'adresse des données précédentes AddA, chargée sur la ligne d'adresse A, avec les données précédemment préparées DatAecc, chargées sur la ligne de données D de la mémoire, et provenant du registre tampon BUF de l'interface de contrôle.

Parallèlement, pendant le troisième cycle III, l'interface de contrôle prépare ECC_MDF les prochaines données à écrire DatBecc, en combinant les données DatBmem lues dans la mémoire à l'adresse AddB de la présente requête, avec les nouvelles données AddBnew, et en calculant le nouveau code correcteur d'erreur attribué au nouveau mot mémoire comprenant la combinaison des données DatBmem et DatBnew.

Après l'écriture, pendant le quatrième cycle IV, les données préparées DatBecc sont enregistrées dans le registre tampon ENRG_BUF de l'interface de contrôle de la mémoire.

En même temps, un test est réalisé sur la voie de sélection HSEL du bus BUS pour vérifier si une nouvelle requête d'accès à la mémoire est émise par un dispositif maître.

Si HSEL est activé (à 1), alors une nouvelle requête est reçue rq_ok. La nouvelle requête peut être une lecture rq_lec ou une écriture rq_ecr en fonction du signal ECR/LEC (respectivement 1 et 0) sur la voie de commande d'écriture HWRITE.

En cas de réception d'une requête de lecture rq_lec, une lecture LEC dans la mémoire est commandée, tandis que les données préparées DatBecc restent enregistrées dans le registre tampon BUF.

En cas de réception d'une requête en écriture rq_ecr, comme illustré par la figure 4, une nouvelle écriture telle que décrite ci-dessus est mise en oeuvre pour une autre adresse AddC et pour des autres nouvelles données DatCnew.

Les données préparées DatBecc sont chargées sur la ligne de données D et écrites dans la mémoire MEM lors du troisième cycle III de cette nouvelle écriture. Des autres données à écrire dans la mémoire DatCecc sont préparées ECC_MDF et enregistrées dans le registre tampon ENRG_BUF lors des nouveaux troisième et quatrième cycles III, IV.

Et, en cas d'absence de réception d'une nouvelle requête rq_nok lors du quatrième cycle IV, c'est-à-dire si le signal HSEL n'est pas activé (à 1) pendant le quatrième cycle IV, alors un cycle d'écriture (cinquième cycle V) est « forcé » par l'interface de contrôle CTRL.

Et, comme illustré sur la figure 4, à l'issue de la seconde écriture, lors du cinquième cycle V, les dernières données à écrire DatCecc enregistrées dans le registre tampon sont écrites dans la mémoire, pendant que la mémoire n'est ni requise pour une écriture, ni requise pour une lecture.

Ainsi l'écriture dans la mémoire est effectivement achevée, et un signal de réinitialisation peut être émis sans risquer de perdre les dernières données préparés DatCecc du registre tampon.

Par ailleurs l'invention n'est pas limitée à ces modes de réalisation et de mise en oeuvre mais en embrasse toutes les variantes, par exemple, l'invention peut être adaptée à d'autres réalisations de mémoires prévoyant un code correcteur d'erreur et un usage d'un registre tampon stockant temporairement des données à écrire.

## Revendications

1. Procédé d'écriture dans une mémoire volatile (MEM) comprenant au moins une réception d'une requête d'écriture dans la mémoire (RQ_ECR), et, en réponse à chaque requête d'écriture dans la mémoire (RQ_ECR) :
- une préparation des données à écrire dans la mémoire (PREP_DatEcc) comprenant un calcul d'un code correcteur d'erreur (ECC) ;
- un enregistrement dans un registre tampon (BUF_DatEcc) des données à écrire dans la mémoire (MEM) ;
**caractérisé en ce que** le procédé d'écriture comprends en outre :
- si aucune nouvelle requête d'écriture ou de lecture dans la mémoire (MEM) n'est reçue (rq_nok) après ledit enregistrement (BUF_DatEcc), une écriture dans la mémoire (ECR_DatEcc) des données à écrire enregistrées dans le registre tampon.

2. Procédé selon la revendication 1, comprenant en outre :
- si une nouvelle requête d'écriture dans la mémoire est reçue (rq_ok) après ledit enregistrement (BUF_DatEcc), une écriture dans la mémoire (MEM) des données à écrire enregistrées dans le registre tampon (ECR_DatEcc) avant l'enregistrement dans le registre tampon (BUF_DatEcc) des données suivantes à écrire dans la mémoire (MEM) préparées en réponse à la nouvelle requête d'écriture dans la mémoire.

3. Procédé selon l'une des revendications 1 ou 2, la requête d'écriture dans la mémoire (RQ_ECR) comprenant une adresse mémoire (AddC) de la mémoire (MEM) et des nouvelles données (DatCnew) ayant une taille inférieure à la taille d'un mot mémoire de la mémoire (MEM), dans lequel ladite préparation des données à écrire (PREP_DatEcc) comprend une lecture de données antérieures enregistrées dans le mot mémoire (DatCmem) contenant l'adresse mémoire (AddC), et le calcul du code correcteur d'erreur (ECC) est calculé sur une combinaison des données antérieures (DatCmem) et des nouvelles données (DatCnew), les données à écrire (DatCecc) comprenant ladite combinaison de données et le code correcteur d'erreur ainsi calculé.

4. Procédé selon l'une des revendications précédentes, dans lequel toute requête d'écriture ou de lecture dans la mémoire (RQ_ECR, RQ_LEC) est transmise sur un bus (BUS) et comprend une activation d'un signal de sélection (HSEL) sur une voie du bus (BUS), le procédé comprenant une détection de l'activation ou non dudit signal de sélection (HSEL) pour évaluer si aucune requête d'accès en écriture ou en lecture dans la mémoire n'est reçue (rq_nok) après ledit enregistrement.

5. Circuit intégré comprenant une mémoire volatile (MEM) et une interface de contrôle de la mémoire (CTRL) destinée à recevoir au moins une requête d'écriture dans la mémoire, et configurée, en réponse à une requête d'écriture dans la mémoire, pour :
- préparer des données à écrire dans la mémoire (MPRP) et calculer un code correcteur d'erreur (ECC) ;
- enregistrer dans un registre tampon (BUF) les données à écrire dans la mémoire (MEM) ;
**caractérisé en ce que** le circuit intégré comprends en outre :
- si aucune nouvelle requête d'écriture ou de lecture dans la mémoire (MEM) n'est reçue (rq_nok) après ledit enregistrement, commander une écriture dans la mémoire (MEM) des données à écrire enregistrées dans le registre tampon (BUF).

6. Circuit intégré selon la revendication 5, l'interface de contrôle (CTRL) étant en outre configurée pour :
- si une nouvelle requête d'écriture dans la mémoire est reçue (rq_ok) après ledit enregistrement, écrire dans la mémoire (MEM) les données à écrire enregistrées dans le registre tampon (BUF) avant d'enregistrer dans le registre tampon (BUF) les données suivantes à écrire dans la mémoire (MEM) en réponse à la nouvelle requête d'écriture dans la mémoire.

7. Circuit intégré selon l'une des revendications 5 ou 6, l'interface de contrôle (CTRL) étant configurée selon l'une des revendications 5 ou 6 en réponse à une requête d'écriture (RQ_ECR) comprenant une adresse mémoire (AddC) de la mémoire (MEM) et des nouvelles données (DatCnew) ayant une taille inférieure à la taille d'un mot mémoire de la mémoire (MEM), dans lequel ladite interface de contrôle de la mémoire (CTRL) est configurée pour lire des données antérieures enregistrées dans le mot mémoire (DatCmem) contenant l'adresse mémoire (AddC), et calculer le code correcteur d'erreur (ECC) sur une combinaison des données antérieures (DatCmem) et des nouvelles données (DatCnew), afin de préparer lesdites données à écrire (DatCecc) comprenant la combinaison de données et le code correcteur d'erreur ainsi calculé.

8. Circuit intégré selon l'une des revendications 5 à 7, dans lequel l'interface de contrôle de la mémoire (CTRL) comporte un circuit d'écriture forcée (ECRFRC) configuré pour évaluer si aucune requête d'écriture ou de lecture dans la mémoire (MEM) n'est reçue (rq_nok) après ledit enregistrement, et pour commander ladite écriture dans la mémoire (MEM) des données à écrire enregistrées dans le registre tampon (BUF) pendant l'absence d'écriture et de lecture dans la mémoire (MEM).

9. Circuit intégré selon l'une des revendications 5 à 8, dans lequel ladite mémoire volatile (MEM) est du type mémoire vive statique.

10. Circuit intégré selon l'une des revendications 5 à 9, dans lequel l'interface de contrôle de la mémoire (CTRL) est configurée pour recevoir lesdites requêtes d'écriture ou de lecture dans la mémoire (RQ_ECR, RQ_LEC) sur un bus (BUS), et l'interface de contrôle de la mémoire (CTRL) est configurée pour détecter l'activation ou non d'un signal de sélection (HSEL) sur une voie dudit bus (BUS) afin d'évaluer si aucune requête d'accès en écriture ou en lecture dans la mémoire n'est reçue (rq_nok) après ledit enregistrement.

11. Système sur puce comprenant un circuit intégré (CI) selon l'une des revendications 5 à 10, un bus (BUS), et un dispositif maître (MT) capable de transmettre des requêtes d'écriture dans la mémoire à l'interface de contrôle de la mémoire (CTRL) via ledit bus (BUS).

## Patentansprüche

1. Verfahren zum Schreiben in einem flüchtigen Speicher (MEM), das mindestens einen Empfang einer Schreibanforderung im Speicher (RQ_ECR), und, als Antwort auf jede Schreibanforderung im Speicher (RQ_ECR), umfasst:
- eine Vorbereitung der im Speicher zu schreibenden Daten (PREP_DatEcc), die eine Berechnung eines Fehlerkorrekturcodes (ECC) umfasst;
- eine Registrierung der im Speicher zu schreibenden Daten (MEM) in einem Pufferregister (BUF_DatEcc);
**dadurch gekennzeichnet, dass** das Verfahren ferner umfasst:
- wenn nach der Registrierung (BUF_DatEcc) keine neue Schreib- oder Leseanforderung im Speicher (MEM) empfangen (rq_nok) wird, ein Schreiben der zu schreibenden, im Pufferregister registrierten Daten im Speicher (ECR_DatEcc) .

2. Verfahren nach Anspruch 1, das ferner umfasst:
- wenn nach der Registrierung (BUF_DatEcc) eine neue Schreibanforderung im Speicher empfangen (rq_ok) wird, ein Schreiben der zu schreibenden, im Pufferregister (ECR_DatEcc) registrierten Daten im Speicher (MEM) vor der Registrierung im Pufferregister (BUF_DatEcc) der folgenden, im Speicher (MEM) zu schreibenden Daten, die als Antwort auf die neue Schreibanforderung im Speicher vorbereitet wurden.

3. Verfahren nach einem der Ansprüche 1 oder 2, wobei die Schreibanforderung im Speicher (RQ_ECR) eine Speicheradresse (AddC) des Speichers (MEM) und neue Daten (DatCnew) umfasst, die eine kleinere Größe als die Größe eines Speicherworts des Speichers (MEM) haben, wobei die Vorbereitung der zu schreibenden Daten (PREP_DatEcc) ein Lesen früherer, im Speicherwort (DatCmem) registrierter Daten umfasst, das die Speicheradresse (AddC) enthält, und die Berechnung des Fehlerkorrekturcodes (ECC) über eine Kombination der früheren Daten (DatCmem) und der neuen Daten (DatCnew) berechnet wird, wobei die zu schreibenden Daten (DatCecc) die Datenkombination und den derart berechneten Fehlerkorrekturcode umfassen.

4. Verfahren nach einem der vorangehenden Ansprüche, wobei jede Schreib- oder Leseanforderung im Speicher (RQ_ECR, RQ_LEC) über einen Bus (BUS) übertragen wird und eine Aktivierung eines Auswahlsignals (HSEL) über einen Weg des Busses (BUS) umfasst, wobei das Verfahren eine Detektion der Aktivierung oder nicht des Auswahlsignals (HSEL) umfasst, um zu beurteilen, ob keine Schreib- oder Lesezugriffsanforderung im Speicher nach der Registrierung empfangen (rq_nok) wurde.

5. Integrierter Schaltkreis, der einen flüchtigen Speicher (MEM) und eine Steuerschnittstelle des Speichers (CTRL) umfasst, die bestimmt ist, mindestens eine Schreibanforderung im Speicher zu empfangen und als Antwort auf eine Schreibanforderung im Speicher ausgelegt ist, um:
- im Speicher zu schreibende Daten (MPRP) vorzubereiten und einen Fehlerkorrekturcode (ECC) zu berechnen;
- in einem Pufferregister (BUF) die im Speicher zu schreibenden Daten (MEM) zu registrieren;
**dadurch gekennzeichnet, dass** der integrierte Schaltkreis ferner umfasst:
- wenn nach der Registrierung keine neue Schreib- oder Leseanforderung im Speicher (MEM) empfangen (rq_nok) wurde, ein Schreiben der zu schreibenden, im Pufferregister (BUF) registrierten Daten im Speicher (MEM) zu befehlen.

6. Integrierter Schaltkreis nach Anspruch 5, wobei die Steuerschnittstelle (CTRL) ferner ausgelegt ist, um:
- wenn nach der Registrierung eine neue Schreibanforderung im Speicher empfangen (rq_ok) wird, die zu schreibenden, im Pufferregister (BUF) registrierten Daten im Speicher (MEM) zu schreiben, bevor die folgenden, im Speicher (MEM) zu schreibenden Daten als Antwort auf die neue Schreibanforderung im Speicher im Pufferregister (BUF) registriert werden.

7. Integrierter Schaltkreis nach einem der Ansprüche 5 oder 6, wobei die Steuerschnittstelle (CTRL) nach einem der Ansprüche 5 oder 6 als Antwort auf eine Schreibanforderung (RQ_ECR) ausgelegt ist, umfassend eine Speicheradresse (AddC) des Speichers (MEM) und neue Daten (DatCnew), die eine kleinere Größe als die Größe eines Speicherworts des Speichers (MEM) haben, wobei die Steuerschnittstelle (CTRL) ausgelegt ist, um frühere, im Speicherwort (DatCmem) registrierte Daten zu lesen, das die Speicheradresse (AddC) enthält, und um den Fehlerkorrekturcode (ECC) über eine Kombination der früheren Daten (DatCmem) und der neuen Daten (DatCnew) zu berechnen, um die zu schreibenden Daten (DatCecc) vorzubereiten, die die Datenkombination und den derart berechneten Fehlerkorrekturcode umfassen.

8. Integrierter Schaltkreis nach einem der Ansprüche 5 bis 7, wobei die Steuerschnittstelle des Speichers (CTRL) einen Forced Writes-Schaltkreis (ECRFRC) aufweist, der ausgelegt ist, um zu beurteilen, ob nach der Registrierung keine Schreib- oder Leseanforderung im Speicher (MEM) empfangen (rq_nok) wurde und um das Schreiben der zu schreibenden, im Pufferregister (BUF) registrierten Daten im Speicher (MEM) während der Abwesenheit des Schreibens und Lesens im Speicher (MEM) zu befehlen.

9. Integrierter Schaltkreis nach einem der Ansprüche 5 bis 8, wobei der flüchtige Speicher (MEM) vom Typ SRAM-Speicherzelle ist.

10. Integrierter Schaltkreis nach einem der Ansprüche 5 bis 9, wobei die Steuerschnittstelle des Speichers (CTRL) ausgelegt ist, um die Schreib- oder Leseanforderungen im Speicher (RQ_ECR, RQ_LEC) über einen Bus (BUS) zu empfangen, und die Steuerschnittstelle des Speichers (CTRL) ausgelegt ist, um die Aktivierung oder nicht eines Auswahlsignals (HSEL) über einen Weg des Busses (BUS) zu ermitteln, um zu beurteilen, ob keine Schreib- oder Lesezugriffsanforderung im Speicher nach der Registrierung empfangen (rq_nok) wurde.

11. System-on-Chip, das einen integrierten Schaltkreis (CI) nach einem der Ansprüche 5 bis 10, einen Bus (BUS) und eine Mastervorrichtung (MT) umfasst, die imstande ist, Schreibanforderungen im Speicher an die Steuerschnittstelle des Speichers (CTRL) über den Bus (BUS) zu übertragen.

## Claims

1. A method for writing in a volatile memory (MEM) comprising at least one reception of a request for writing in the memory (RQ_ECR), and, in response to each request for writing in the memory (RQ_ECR):
- a preparation of the data to be written in the memory (PREP_DatEcc) comprising a calculation of an error correcting code (ECC);
- a recording in a buffer register (BUF_DatEcc) of the data to be written in the memory (MEM);
**characterised in that** the writing method further comprises:
- if no new write or read request in the memory (MEM) is received (rq_nok) after said recording (BUF_DatEcc), a writing in the memory (ECR_DatEcc) of the data to be written recorded in the buffer register.

2. The method according to claim 1, further comprising:
- if a new request for writing in the memory is received (rq_ok) after said recording (BUF_DatEcc), a writing in the memory (MEM) of the data to be written recorded in the buffer register (ECR_DatEcc) before the recording in the buffer register (BUF_DatEcc) of the following data to be written in the memory (MEM) prepared in response to the new request for writing in the memory.

3. The method according to one of claims 1 or 2, the request for writing in the memory (RQ_ECR) comprising a memory address (AddC) of the memory (MEM) and new data (DatCnew) having a size less than the size of a memory word of the memory (MEM), wherein said preparation of the data to be written (PREP_DatEcc) comprises a reading of previous data recorded in the memory word (DatCmem) containing the memory address (AddC), and the calculation of the error correcting code (ECC) is calculated on a combination of previous data (DatCmem) and new data (DatCnew), the data to be written (DatCecc) comprising said combination of data and the error correcting code thus calculated.

4. The method according to one of the preceding claims, wherein any write or read request in the memory (RQ_ECR, RQ_LEC) is transmitted on a bus (BUS) and comprises an activation of a selection signal (HSEL) on a channel of the bus (BUS), the method comprising detecting the activation or not of said selection signal (HSEL) to evaluate whether no write or read request for access to the memory is received (rq_nok) after said recording.

5. An integrated circuit comprising a volatile memory (MEM) and a memory control interface (CTRL) intended to receive at least one request for writing in the memory, and configured, in response to a request for writing in the memory, for:
- preparing data to be written in the memory (MPRP) and calculating an error correcting code (ECC);
- recording in a buffer register (BUF) the data to be written in the memory (MEM);
**characterised in that** the integrated circuit further comprises:
- if no new write or read request in the memory (MEM) is received (rq_nok) after said recording, ordering a writing in the memory (MEM) of the data to be written recorded in the buffer register (BUF).

6. The integrated circuit according to claim 5, the control interface (CTRL) being further configured for:
- if a new request for writing in the memory is received (rq_ok) after said recording, writing in the memory (MEM) the data to be written recorded in the buffer register (BUF) before recording in the buffer register (BUF) the next data to be written in the memory (MEM) in response to the new memory write request.

7. The integrated circuit according to one of claims 5 or 6, the control interface (CTRL) being configured according to one of claims 5 or 6 in response to a write request (RQ_ECR) comprising a memory address (AddC) of the memory (MEM) and new data (DatCnew) having a size less than the size of a memory word of the memory (MEM), wherein said memory control interface (CTRL) is configured to read previous data recorded in the memory word (DatCmem) containing the memory address (AddC), and calculating the error correcting code (ECC) on a combination of the previous data (DatCmem) and the new data (DatCnew), in order to prepare said data to be written (DatCecc) comprising the combination of data and the error correcting code thus calculated.

8. The integrated circuit according to one of claims 5 to 7, wherein the memory control interface (CTRL) includes a forced write circuit (ECRFRC) configured to assess whether any write or read request in the memory (MEM) is received (rq_nok) after said recording, and to control said writing in the memory (MEM) of the data to be written recorded in the buffer register (BUF) during the absence of writing and reading in memory (MEM).

9. The integrated circuit according to one of claims 5 to 8, wherein said volatile memory (MEM) is of the static random access memory type.

10. The integrated circuit according to one of claims 5 to 9, wherein the memory control interface (CTRL) is configured to receive said write or read requests in the memory (RQ_ECR, RQ_LEC) on a bus (BUS), and the memory control interface (CTRL) is configured to detect the activation or not of a selection signal (HSEL) on a channel of said bus (BUS) in order to assess whether no write or read request for access to the memory is received (rq_nok) after said recording.

11. A system on chip comprising an integrated circuit (IC) according to one of claims 5 to 10, a bus (BUS), and a master device (MT) capable of transmitting requests for writing in the memory to the interface memory control (CTRL) via said bus (BUS).
